# EUROPEAN PATENT SPECIFICATION

(11) **EP 3 343 210 B1**
(45) Date of publication and mention of the grant of the patent: **18.11.2020**
(21) Application number: 16207649.1
(22) Date of filing: 30.12.2016
(51) Int. Cl.: G01N 23/203, H01J 37/147, H01J 37/20, H01J 37/26

(54) **CHARACTERIZATION OF REGIONS WITH DIFFERENT CRYSTALLINITY IN MATERIALS**
CHARAKTERISIERUNG VON BEREICHEN MIT UNTERSCHIEDLICHER KRISTALLINITÄT IN MATERIALIEN
CARACTÉRISATION DE RÉGIONS AYANT DIFFÉRENTES CRISTALLINITÉS DANS DES MATÉRIAUX

(43) Date of publication of application: 04.07.2018
(73) Proprietor: IMEC vzw, 3001 Leuven (BE)
(72) Inventor: SCHULZE, Andreas, 3001 Leuven (BE); VANDERVORST, Wilfried, 3001 Leuven (BE)
(74) Representative: DenK iP

(56) References cited:
- EP-A2- 2 320 217
- WO-A1-2013/004990
- ZAEFFERER STEFAN ET AL: "Theory and application of electron channelling contrast imaging under controlled diffraction conditions", ACTA MATERIALIA, vol. 75, 24 May 2014 (2014-05-24), pages 20-50, XP028861954, ISSN: 1359-6454, DOI: 10.1016/J.ACTAMAT.2014.04.018

## Description

### Field of the invention

The invention relates to the field of characterizing materials. More specifically, it relates to methods and systems for characterizing regions with different crystallinity, in particular for characterizing for example defects in crystalline materials.

### Background of the invention

Electron channeling contrast imaging (ECCI) has been demonstrated to be a powerful technique to image single extended crystalline defects, such as for example dislocations or stacking faults. This technique hence allows determining the density of these crystalline defects in various materials. For this purpose, a focused electron beam is scanned across the sample surface while the intensity of backscattered or forward scattered electrons is mapped, as described by Wilkinson et al. in Micron 28 (4) (1997) 279. The intensity of backscattered or forward scattered electrons depends on the lattice parameter as well as on the orientation of the lattice planes, with respect to the incident electron beam. Crystalline defects cause a local deformation (extending over a few nm) of the lattice planes which leads to a local variation of the backscattered intensity which can be mapped using a backscatter detector. To spatially resolve single defects, the electron beam needs to be smaller than the spatial extent of the lattice deformation.

In case of lowly defective samples, a rather large area needs to be analyzed by scanning the focused electron beam across, in order to derive statistically relevant information on the defect density. The overall measurement time is then determined by the number of pixels (=scan area/electron beam spot size) as well as the integration time for each pixel and hence can add up to several hours. This hampers the application of electron channeling contrast imaging as a routine analysis tool for defect characterization on lowly defective materials.

There is still a need for good methods and devices for characterizing regions with different crystallinity, in particular for characterizing for example defects in crystalline materials. There is still a need for good methods and devices for characterizing epitaxially grown materials.

EP2320217 describes a selected area channeling pattern method and particle optical system for performing such a method.

### Summary of the invention

It is an object of the present invention to provide good methods and devices for characterizing regions with different crystallinity.

It is an advantage of embodiments of the present invention that measurement contributions stem from regions to be characterized and not from the background, thus resulting in a good signal to noise ratio.

It is an advantage of embodiments of the present invention that accurate characterization of regions inducing deviations in crystalline properties can be performed such as for example defects in a crystalline material, such as distortion in lattice planes or other crystalline defects, or such as for example confined crystalline structures in a non-crystalline matrix.

It is an advantage of embodiments of the present invention that measurements can be performed with reduced overall measurement time.

It is an advantage of embodiments of the present invention that measurements with a good sensitivity can be obtained.

It is an advantage of embodiments of the present invention that a good signal to noise ration can be obtained even for measurements with a short measurement time.

It is an advantage of embodiments of the present invention that fast and nondestructive imaging of distributions and density assessment of deviations in various crystalline materials, e.g. defects in crystalline materials, can be obtained.

It is an advantage of embodiments of the present invention that wafer scale metrology can be obtained with an acceptable wafer throughput, i.e. that full wafer analysis can be obtained in reasonable time.

The above object is obtained by a method and system according to embodiments of the present invention.
The present invention relates to a method for characterizing a region in a sample under study, the sample under study comprising a first region having first crystalline properties and a second region having second crystalline properties different from the first crystalline propertiess, the method comprising:
irradiating the sample under study with an electron beam, the average relative angle between the electron beam and the sample under study being selected so that a contribution in the backscattered and/or forward scattered signal of the first region is larger than a contribution of the second region,
detecting the backscattered and/or forward scattered electrons, and
deriving a characteristic of the first and/or the second region in the sample under study from the detected backscattered and/or forward scattered electrons,
wherein:
   said irradiating comprises modulating the instantaneous relative angle α between the electron beam and the sample under study with a predetermined modulation frequency during said irradiating, and
   wherein said detecting comprises detecting the resulting modulated backscattered or forward scattered electrons signal modulated at the predetermined modulation frequency.
In some embodiments, the first region may correspond with a region having a deviation in crystalline properties, compared to a second region being a reference region with reference crystalline properties. In some embodiments, the first region may be a defect or defect region introducing a deviation in crystalline properties. Such defects may for example be crystalline defects, such as for example single extended crystalline defects like dislocations or stacking faults. The reference region then typically is a crystalline structure. In these applications, the elements or regions of interest, also referred to as defects, thus are crystalline defects or positions where crystalline defects occur within the crystalline material.

The first and second region also may refer to e.g. a composite material with nanospheres in an amorphous matrix. Thus, in some applications, deviations in a sample under study will refer to situations wherein deviations are present in confined crystalline structures which are themselves embedded in a non-crystalline matrix, one example thereof being fins introduced in a shallow trench isolation matrix. Consequently, it is not required that the sample under study is a full crystalline matrix.

More generally, deviations correspond with elements or regions of interest for which one wants to determine a characteristic such as for example a density, a composition, a crystallinity. The remaining part of the sample under study then corresponds with the material wherein the elements or regions of interest are embedded and may be referred to as the matrix wherein the deviations, e.g. defects, are embedded. Such a matrix may be fully or partly crystalline.

It is an advantage of embodiments of the present invention that by increasing the beam size, a reduced number of pixels needs to be analysed for a given sample area. It is an advantage of embodiments of the present invention that by increasing the beam size, a reduced integration time per pixel is required, since there is a larger beam current and hence backscatter signal. It is furthermore an advantage that, by detecting using a modulated relative angle between the electron beam and the sample under study modulated at a given predetermined frequency, detection can be performed with enhanced sensitivity to deviations, since contributions in the angle modulated backscattered or forward scattered electrons signal from deviation free regions will be small or even negligible.
The sample under study and the average beam size may be selected to be larger than the size of the region to be characterized, e.g. the deviation to be characterized.
The detecting may be performed using lock-in amplification at the angle modulation frequency. It is an advantage of embodiments of the present invention that detection at the angle modulation frequency can be easily obtained by implementing a lock-in amplification technique, lock-in amplification techniques being as such well-known and easily implementable.
The average relative angle between the electron beam and the sample understudy may be such that the channeling condition is fulfilled for the second region, i.e. the reference region. The channeling condition is defined as the angle condition for the relative angle under which a minimal backward or forward scattering electron signal is obtained.
The modulation of the instantaneous relative angle α between the electron beam and the sample under study may be obtained by periodically tilting of the sample. It is an advantage of embodiments of the present invention that a mechanically easily implementable solution can be used for inducing the modulation of the incidence angle.
The modulation of the instantaneous relative angle α between the electron beam and the sample under study may be obtained by electron beam rocking. It is an advantage of embodiments of the present invention that known techniques for beam rocking can be used for implementing modulation of the incidence angle.
The first regions in the sample under study may be crystalline defects in a crystalline structure, said deriving may comprise determining a density of crystalline defects. It is an advantage of embodiments of the present invention that a density of crystalline defects such as dislocations or stacking faults can be determined, even if the density is relatively low.
The sample under study may be confined crystalline structures embedded in a non-crystalline matrix, the deriving may comprise determining a density of deviations in the confined crystalline structures. It is an advantage of embodiments of the present invention that also detection of deviations in crystalline structures embedded in a non-crystalline matrix can be performed. An example of such crystalline structures may be fins in a shallow trench isolation matrix. It thereby is an advantage that the non-crystalline matrix, e.g. amorphous matrix, does not contribute to the backscattered or forward scattered electron signal. The modulation technique then allows to decouple the contributions from both materials thus allowing the analysis of deviations in crystalline features smaller than the spot size of the primary electron beam.
The method may comprise detecting a region corresponding with deviations in crystalline features, obtaining an indication on the density of deviations and spotting a region of interest and decreasing the electron beam spot size, e.g. a beam spot diameter, for localizing a deviation of crystalline properties.
The present invention also relates to a controller for controlling a system for characterizing a region in a sample under study by electron channeling contrast imaging, the sample under study comprising a first region having first crystalline properties and a second region having second crystalline properties, the controller being configured for modulating a relative instantaneous angle α between an electron beam and the sample under study with a predetermined modulation frequency during an irradiating step, and for detecting backscattered or forward scattered electrons at the modulation frequency during a detection step.
The present invention relates to a system for characterizing a region in a sample under study by electron channeling contrast imaging, the sample under study comprising a first region having first crystalline properties and a second region having second crystalline properties different from the first crystalline properties, the system comprising
a sample holder for holding the sample under study
an irradiation system for irradiating the sample under study with an electron beam, the sample holder and/or the irradiation system allowing alignment for providing an average relative angle between the electron beam and the sample under study being selected so that a contribution in the backscattered or forward scattered signal of the first region is larger than a contribution of the second region, and
a detector for detecting backscattered or forward scattered electrons upon interaction of the electron beam and the sample under study,
wherein the system furthermore comprises a controller as described above.
The system may comprise a lock-in amplifier for modulating the relative instantaneous angle between the electron beam and the sample under study and for detecting the backscattered or forward scattered electrons at the modulation frequency.
The system may be equipped with a sample tilting means and/or a beam rocking means for inducing a modulation of the instantaneous relative angle α between the electron beam and the sample under study.
The system furthermore may comprise a processor for deriving a characteristic of a first crystalline region or a second crystalline region in the sample under study based on the detected backscattered or forward scattered electrons.
The irradiation source furthermore may be configured for irradiating the sample under study with an electron beam having an average beam size, e.g. average beam diameter, selected to be larger than the size of the region to be characterized, e.g. the deviation. In some embodiments, the average beam diameter may be at least 10nm on the sample under study.
The present invention also relates to a system for characterizing a region in a sample under study by electron channeling contrast imaging, the sample under study comprising a first region having first crystalline properties and a second region having second crystalline properties, the system comprising
a sample holder for holding the sample under study,
an irradiation system for irradiating the sample under study with an electron beam,
a detector for detecting backscattered or forward scattered electrons upon interaction of the electron beam and the sample under study, and
a controller operably connected to the sample holder and/or the irradiation system and to the detector, the controller comprising a memory provided with a program to execute characterizing a region in a sample under study, when run on the controller by: irradiating the sample under study with an electron beam and modulating, during said irradiating, the instantaneous relative angle α between the electron beam and the sample under study with a predetermined modulation frequency, the average relative angle between the electron beam and the sample under study being selected so that a contribution in the backscattered or forward scattered signal of the first region is distinguishable from a contribution of the second region,
detecting the resulting modulated backscattered or forward scattered electrons signal modulated at the predetermined modulation frequency, and
deriving a characteristic of the first and/or the second region in the sample understudy from the detected backscattered or forward scattered electrons.
The present invention also relates to a computer program product comprising instructions which, when executed on a processing means, induce a method as described above.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG. 1 shows (left) an electron beam irradiation a crystalline sample and (right) the backscattered intensity according to the angle between the beam and the crystal planes.
FIG. 2 shows a flowchart of a method according to embodiments of the present invention.
FIG. 3 and FIG. 4 show different schematic embodiments of a system according to embodiments of the present invention.
FIG. 5 shows a large beam irradiating over a large sample area.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Where in embodiments of the present invention reference is made to a first region having first crystalline properties, reference may be made respectively to a region of interest for which properties are to be determined, e.g. defects or confined crystalline structures (which are embedded in a non-crystalline matrix). Where in embodiments of the present invention reference is made to a second region having second crystalline properties, reference may be made to a region used as a reference region, e.g. a defect-free crystalline region or a non-crystalline matrix at positions wherein the confined crystalline structures are not embedded.

Where in embodiments of the present invention reference is made to the instantaneous relative angle α between the beam and the substrate, reference is made to the angle between the beam and the substrate. Where reference is made to the average relative angle, reference is made to the average angle obtained by averaging the instantaneous relative angle α over time (thus averaging out the modulation).

In a first aspect, the present invention relates to a method for characterizing a region in a sample under study. The sample under study comprises a first region having first crystalline properties and a second region having second crystalline properties. The method comprises irradiating the sample under study with an electron beam, whereby the average relative angle between the electron beam and the sample under study is being selected so that the contribution in the backscattered or forward scattered signal of the first region is different from a contribution of the second region. In some embodiments, the first region may be a defect region or defect and the second region may be a defect free region. A defect region or defect may refer to a deviation typically being smaller in size than the surroundings. Defects or defect regions may for example be crystalline defects, such as for example single extended crystalline defects like dislocations or stacking faults. Alternatively, the first and second region could refer to e.g. a composite material with nanospheres in an amorphous matrix, or e.g. confined crystalline structures embedded in a non-crystalline matrix.

The method also comprises detecting the backscattered and/or forward scattered electrons, and deriving a characteristic of the first or the second region in the sample under study from the detected backscattered or forward scattered electrons. Irradiating thereby comprises irradiating with an electron beam and modulating the instantaneous relative angle between the electron beam and the sample under study with a predetermined modulation frequency during said irradiating. Detecting comprises detecting the resulting modulated backscattered or forward scattered electrons signal modulated at the predetermined frequency.

By way of illustration, embodiments of the present invention not being limited thereto, standard and optional features will further be described with reference to exemplary systems shown in the drawings. In the examples shown, the principle will be explained using a first region being a crystal defect and a second region being a defect free zone. Nevertheless, as indicated above, embodiments are not limited thereto.

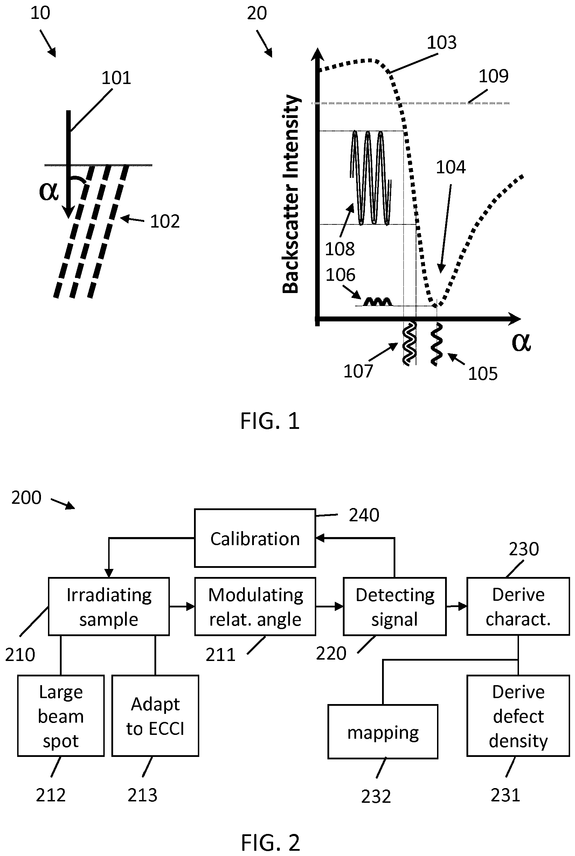

FIG. 1 shows, on the diagram 10 indicated at the left, an electron beam 101 (e.g. a primary electron beam) applied to a sample. The instantaneous angle between the beam 101 and the lattice planes 102 of the sample is the instantaneous relative angle alpha (α). On graph 20 of FIG. 1 shown at the right hand side, the typical backscatter intensity 103 per unit area of scattered electrons is shown as function of the angle α between the electron beam 101 and the lattice planes 102. At angles under the Bragg angle (e.g. between α = 0 and higher), the scatter intensity 103 is high, but it drops fast at or near the Bragg position, becoming minimum in the channelling condition 104. When the angle of incidence of the beam is set to the channelling condition 104 for a region corresponding with a defect free region, e.g. in absence of defects, upon periodic modulation 105 of the beam angle, the variation 106 of amplitude will be (near) zero. However, at a defect region, the incident beam is slightly off the channelling condition 105, and upon the same small periodic modulation 107 of the beam angle, a strong modulation 108 of the back-scatter signal takes place.

Embodiments of the present invention may be used with large electron beam spot sizes. The embodiments can be used to detect defects even at low defect density. Normally, the integrated backscatter signal induced by a large electron beam is dominated by electrons back scattered from the sample, for example from the defect free region, even if the sample is oriented in channelling condition. This represents the large background signal 109 of the graph 20, and it is unrelated to the defects. In embodiments of the present invention, a few defects or even a single defect would give rise to a detectable signal, because the beam angle is set close or at the Bragg condition at the defect site, which causes a strong modulation of the back-scatter signal upon periodic modulation of the beam angle, rather than just a marginal variation in backscatter intensity due to lattice deformation.

When using a large beam spot size, the area of the sample within the electron beam spot will show an increase of the scattered intensity with the number of defects, because the area affected by the defect induced lattice distortion will increase. By detecting the signal at the modulated frequency, a nearly background free signal is obtained, providing enhanced S/N ratio.

FIG. 2 shows, in the flowchart, an exemplary method 200 of characterizing a region in a sample under study with enhanced sensitivity using an electron beam. The method may for example be an electron scanning back- or forward-scattering microscopy technique, for example within an ECCI framework, etc. The method comprises irradiating 210 a sample with an electron beam under an angle such that the contribution of the scattered signal (either back or forward-scattered) of a first region, for example a region comprising defects can be distinguished from the contribution of a second region, for example a defect-free region. For example, the contribution of the first region may be larger than that of the defect-free region. The method further comprises modulating 211 the instantaneous relative angle α between the incident electron beam and the sample. The latter can in one embodiment be obtained by electron beam rocking, using an alternating magnetic field using coils, e.g. alignment and/or deflection coils, in the alignment column of the analysis device, or by any other suitable means. This solution is easily implementable using existing means, or even by software. In other embodiments, the sample can be periodically tilted using a suitable sample holder, for example. This mechanical solution is easily implementable, for example in adapting existing holders. However, the present invention may use any suitable technique, in order to obtain a modulation of the instantaneous relative angle α between the beam and the sample under study (e.g. between the beam and the lattice planes of the sample) with a predetermined frequency.

The modulation parameters, such as for example the modulation frequency or amplitude, can be adapted taking into account the type of material of the region used as reference region (i.e. for which channeling conditions are selected) and/or the type of material of the region having deviating crystalline properties and which is to be characterized/analyzed, a scattering factor thereof, a Bragg angle, an inter planar distance, an incidence angle, etc. The modulation frequency, and optionally the amplitude of the modulation, can be predetermined in order to obtain an angular modulation small enough to produce undetectable changes of scatter intensity in a free-defect material at the Bragg condition or near the Bragg condition, but which would produce a detectable modulation in case there is a defect. The method further comprises detecting 220 the signal from the scattered electrons at the predetermined modulation frequency. It is to be noticed that calibration of the modulation parameters may be performed to optimize the modulation. Calibrating 240 the modulation parameters may be performed in a defect-free region of the sample, by for example scanning modulation frequencies and selecting the maximum modulation frequency at which there is no or a minimum detectable change in the scattered signal.

Finally, the method comprises deriving 230, from the detected signal, a characteristic of defects in the sample under study from the detected scattered electrons. Deriving a characteristic of defects may comprise deriving 230 a density of crystalline defects, such as dislocations or stacking faults, which are usually very difficult to observe and analyze. The present invention allows detecting and analyzing (quantitatively and/or by estimation) the density of such defects, even if the density is low. The present technique allows analyzing crystalline structures and defects thereof in confined crystalline structures, for example in locally ordered zones of an amorphous (or short-range ordered) matrix, in crystalline structures embedded in non-crystalline matrices, such as fins in shallow trench isolations, in oxides, etc. In embodiments of the present invention, the contribution of the matrix to the scattered electron signal does not affect the measured signal. The modulation technique allows to decouple the contributions of the matrix and of the crystalline material, allowing analysis of defects in crystalline features smaller than the spot size of the electron beam. The speed of measurement is also higher.

In some embodiments, the present invention also may comprise a mapping step, whereby for a detected region corresponding with a deviation, a location is determined. Such mapping may for example be performed by first obtaining an indication of the density of deviations and spotting a region of interest and thereafter, with decreased electron beam spot size, localizing the deviation.

In embodiments of the present invention, the method also may comprise selecting 212 a beam diameter (beam spot) larger than the lattice distortion field (e.g. strain field) of the defects under study. This lattice distortion field is usually material- and defect-dependent, but traditionally it encompasses several crystalline planes. The exact value can be obtained by simulation, by study using contrast studies such as dark field microscopy, etc. It usually can be well estimated. In some embodiments of the present invention, the spot size is orders of magnitude larger than a nanometer, for example it may be tens of nanometer, or even hundreds of nanometer. In some embodiments, the average beam diameter can be at least 10 nm. A typical scanning electron microscope (SEM) provides spot sizes higher than 1 nm. The method may be applicable to scanning electron microscopy techniques but transmission techniques can also benefit. Using a large beam diameter, e.g. a spot size being larger than the dimension of the region under study, typically may be performed when fast scanning is envisaged whereby an indication of the concentration of regions under study, e.g. defects, is to be obtained. For obtaining an accurate location, typically the beam size is to be reduced. Such mapping/localization typically is performed in a separate step.

In embodiments of the present invention, a lock-in amplification can be used for signal detection. Because of the strong modulation of the scattered signal of defects under periodic modulation, when using a lock-in amplifier, it is easy to obtain a signal characteristic for the presence of defects based on the amplitude of the backscatter intensity at the modulation frequency. The lock-in amplifier allows to decouple the contributions from a crystal with defects and the rest of the material.

For example, in the case of crystalline structures embedded in non-crystalline matrices, such embodiments allow the analysis of the defects (type, structure, orientation, etc.) in crystalline features smaller than the spot size of the primary electron beam. This decoupling can enhance S/N ratio. For example, it may be applied to confined crystalline structures embedded in a non-crystalline matrix (e.g. fins in shallow trench isolation matrix, nanospheres in an amorphous matrix, etc). A periodic modulation of the beam angle will not affect the backscatter signal originating from the amorphous matrix, but only the backscatter signal coming from the crystalline material. Decoupling of the contributions from the crystalline structures and from the non-crystalline matrix (e.g. amorphous matrix) by using the modulated signal will thus allow the analysis of the defectivity in crystalline features smaller than the spot size of the primary beam, since the contribution of the non-crystalline matrix is filtered out.

Methods according to embodiments of the present invention are especially suitable for performing ECCI. As indicated above, the average relative angle beam-sample thereby is selected to obtain channeling condition when measuring on a reference region, i.e. a region showing no deviations, resulting in a minimal scattering (forward or backward) signal contribution from the reference region when detection is performed at the modulation frequency. This results in a significant larger contribution to the scattered signal for regions with deviations, e.g. defects, than the contribution to the scattered signal in regions without deviations, i.e. reference regions such as for example defect-free regions.

For example, in ECCI, an electron beam can be aligned with the lattice planes of a defect-free region of the material such that channeling condition is fulfilled (e.g. detecting a minimum backscatter intensity). This can be done during the measurement (e.g. as a calibration step), or before, if the orientation of the crystal is known.

When a large spot size of the primary electron beam is selected 212, the angle between electron beam and lattice planes in regions containing, or nearby, defects will be off-channeling condition, due to defect induced lattice deformation. This leads to an increased backscatter probability. However, a smaller spot size may be used, improving localization analysis of the defects, which may be interesting in study of interlayers, interphases and interfaces, boundaries, etc.

The method may include mapping 232 the sample.

Speed of scanning can be increased, e.g. using a wide spot that allows covering large areas, reducing integration time per pixel due to the larger scattering signal, and reducing the number of pixels required, because the angle orientation of the beam reduces signal from scattering on undistorted (perfectly crystalline) areas, and increases the signal from scattering on strained (defected) areas thanks to the modulation of the incident angle of the beam.
In a second aspect, the present invention relates to a material characterization system, in particular a system suitable to detect and analyze deviations in crystalline properties, such as for example caused by defects. The system is adapted for characterizing a region in a sample under study by electron channeling contrast imaging. Typically, the sample under study comprises a first region having first crystalline properties and a second region having second crystalline properties. The system comprises a sample holder for holding the sample under study and an irradiation system for irradiating the sample under study with an electron beam. The irradiation system and/or the sample holder are configured for providing an average relative angle between the electron beam and the sample under study being selected so that the contribution in the backscattered or a first region is distinguishable from a contribution of a second region. The system also comprises a detector for detecting backscattered and/or forward scattered electrons upon interaction of the electron beam and the sample under study. The system furthermore comprises a controller for modulating the instantaneous relative angle α between the electron beam and the sample under study with a predetermined modulation frequency during said irradiating, and for detecting the backscattered or forward scattered electrons at the modulation frequency.

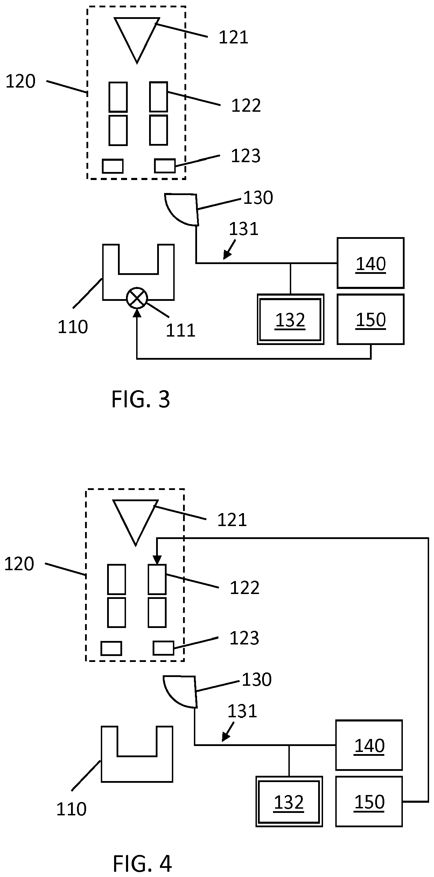

FIG. 3 shows, by way of example, an exemplary system 100. The system comprises a sample holder 110, in order to place a sample. The holder may be a dedicated or a standard holder. For example, a dedicated holder may comprise tilting means 111, such as a piezoelectric actuator, a motor, etc.

The system further comprises an irradiation system 120 for irradiating the sample under study with an electron beam. The system may comprise an electron source 121 such as an emission gun, a cathode, etc.

The irradiation system and/or the sample holder are adapted and configured for providing an average relative angle between the electron beam and the sample under study such that the contribution in the backscattered and/or forward scattered signal of one region, e.g. a defect region, is larger than the contribution of another region, such as for example a defect-free region being used as a reference region. For example, a set of alignment coils 122 can be included, for accurately adjusting the angle of incidence of the beam. The irradiation source may comprise means for aligning the electron beam to an average relative angle of interest (e.g. the channeling angle in an ECCI framework). In alternative embodiments, the holder itself may be configured to provide tilting of the sample, for example orienting the lattice planes of the sample with respect to the incident beam so as to obtain the angle of interest. In further embodiments of the present system, both beam alignment and sample alignment can be provided.

In some embodiments of the present invention, the irradiation source 120 is configured for irradiating the sample under study with an electron beam having an average beam diameter spot size larger than the size of the region to be characterized, i.e. being larger than the region having deviating crystalline properties. In some embodiments, the average beam diameter may be at least 10nm, when evaluated on the sample under study. For example, for controlling the beam diameter, alignment coils and/or electromagnetic lenses 123 can be used. Accurate detection and analysis of crystalline defects is possible using a wide beam diameter (or spot size), which reduces considerably the analysis time, allowing increasing the backscatter signal due to the larger beam current (and reducing both number of pixels required to map an area, as well as less integration time).

The system further comprises a detector 130 for detecting scattered electrons upon interaction of the electron beam and the sample under stud. For example, the system may comprise a forward scattered detector, or a backscatter detector, or a combination thereof . For example, photodiodes, solid state detectors, e.g. for elastic back-scatter, or any other suitable detector in the art can be used.

The detector 130 may comprise an output 131, for example a recording and/or visualization unit 132. Additionally or alternatively, the output can be sent to a processing unit, e.g. a processor 140, which can be used as an analysis tool. For example, it can be used to derive characteristics of the sample.

The system further comprises a controller 150. This controller enables modulation of the instantaneous relative angle between the electron beam and the sample under study. The modulation can be performed with a predetermined modulation frequency during said irradiating. The system can detect the backscattered and/or forward scattered electrons at the modulation frequency. For example, the processor 140 may be adapted to derive characteristics of defects in the sample, based on the detected electrons in the detector 130 when the angular position of the sample and/or beam is modulated at the frequency set by the controller 150.

The system, e.g. the controller 150, may also comprise means to adjust the modulation parameters, according to the type of sample, target defects, and other experimental circumstances. For example, the controller 150 may be an adjustable analogue controller, or a programmable controller, or a hybrid device.

While in the exemplary embodiment of FIG. 3, the controller induces modulation in the sample itself by controlling the motor 111 of the holder 110, in other embodiment shown in FIG. 4, the controller induces modulation in the irradiation system, e.g. in the alignment coils 122. In other embodiments, the controller may induce and control modulation of the instantaneous relative angle α by controlling both the tilting means 111 and the irradiation system 120.

In embodiments of the present invention, the controller 150 comprises a lock-in amplifier, improving the decoupling of contributions from a defect in a crystal and the rest of the sample.
According to embodiments of the present invention, a system 100 for characterizing a region in a sample under study by electron channeling contrast imaging is also disclosed, wherein the system comprises a controller operably connected to the sample holder 110 and/or the irradiation system 120 and to the detector 130 and wherein the controller 150 comprising a memory provided with a program to execute characterizing a region in a sample under study, when run on the controller 150, according to a method as described above. In some embodiments, the system therefore is adapted for irradiating the sample under study with an electron beam and modulating, during said irradiating, the instantaneous relative angle α between the electron beam and the sample under study with a predetermined modulation frequency, the average relative angle between the electron beam and the sample under study being selected so that a contribution in the backscattered or forward scattered signal of the first region is distinguishable from a contribution of the second region, detecting the resulting modulated backscattered or forward scattered electrons signal modulated at the predetermined modulation frequency, and deriving a characteristic of the first and/or the second region in the sample under study from the detected backscattered or forward scattered electrons.

In a third aspect of the present invention, a controller is disclosed for enabling an analysis of a region in a sample according to embodiments of the first aspect. The controller may comprise a processor, and it may be integrated with other controllers of a characterization system. The controller allows controlling the modulation of the instantaneous relative angle α between an electron beam and the sample under study with a predetermined modulation frequency during irradiation. The modulation may be performed by modulating the electron beam angle orientation, by modulating the sample angle orientation itself, or by modulating the orientation of both the sample and beam.

The system of the second aspect and the controller may be adapted and automated for performing the method of the first aspect in a programmable way, for example in a program running in a processor. Whereas the following example is explained for a first region being a defect and a second region being a defect-free region, also referred to as reference region, it will be clear that applications with other first regions having a deviation of crystalline properties with respect to second regions having other crystalline properties are also envisaged.

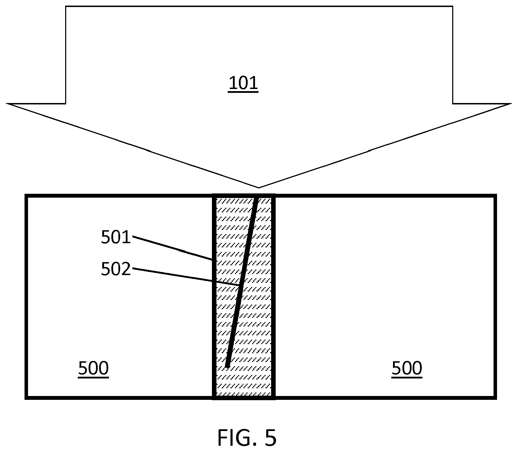

An example of application is shown in FIG. 5, in which an electron beam 101 with a large spot size is applied to a crystalline sample. The sample comprises areas 500 of perfect crystallinity, and strained areas 501, in which the crystal presents deformation due to defects such as the dislocation 502. The electron beam is oriented with respect to the orientation of the perfect crystal such that on average channeling condition is fulfilled for the areas 500 of perfect crystallinity. According to embodiments of the present invention, modulation 105 of the beam angle is applied such that the instantaneous relative angle α changes at a predetermined frequency. When detecting the scatter contribution at the modulation frequency of the relative angle between the beam and the sample, the areas 500 of perfect crystallinity interacting with the large beam do not significantly contribute to the background, whereas the strained areas interacting with the large beam, contribute significantly to the scattered signal, detected at the modulation frequency. In this way, good detection of strained regions can be performed, with a good S/N ratio. Essentially, using a wide beam 101, it thus is possible to detect strained regions with a low or no contribution from electrons scattered from areas 500 without defects, while having a high contribution from electrons scattered from strained areas 501 with defects.

Embodiments of the present invention advantageously results in accurate and fast analysis of defects of semiconductor wafers, which enables wafer scale metrology at high throughput and improves quality control of semiconductor processing.

## Claims

1. A method (200) for characterizing a region in a sample under study, the sample under study comprising a first region having first crystalline properties and a second region having second crystalline properties different from the first crystalline properties, the method (200) comprising:
irradiating (210) the sample under study with an electron beam, the average relative angle between the electron beam and the sample under study being selected so that a contribution in the backscattered or forward scattered signal of the first region is larger than a contribution of the second region,
detecting (220) the backscattered or forward scattered electrons, and
deriving (230) a characteristic of the first and/or the second region in the sample under study from the detected backscattered or forward scattered electrons,
the method **characterised in that**:
said irradiating (210) comprises modulating (211) the instantaneous relative angle α between the electron beam and the sample under study with a predetermined modulation frequency during said irradiating (210), and
wherein said detecting (220) comprises detecting (220) the resulting modulated backscattered or forward scattered electrons signal modulated at the predetermined modulation frequency.

2. A method (200) according to claim 1, wherein: the sample under study and the average beam size are selected to be larger than the size of the region to be characterised.

3. A method (200) according to any of the previous claims, wherein: the detecting (220) is performed using lock-in amplification at the angle modulation frequency.

4. A method (200) according to any of the previous claims, wherein: the average relative angle between the electron beam and the sample under study is such that the channeling condition is fulfilled for the second region.

5. A method (200) according to any of the previous claims, wherein the modulation of the instantaneous relative angle α between the electron beam and the sample under study is obtained by periodically tilting of the sample.

6. A method (200) according to any of the previous claims, wherein the modulation of the instantaneous relative angle α between the electron beam and the sample under study is obtained by electron beam rocking.

7. A method (200) according to any of the previous claims, the first regions in the sample under study being crystalline defects in a crystalline structure, said deriving (230) comprising determining (231) a density of crystalline defects.

8. A method (200) according to any of claims 1 to 6, the sample under study being confined crystalline structures embedded in a non-crystalline matrix, said deriving (230) comprising determining (231) a density of deviations in the confined crystalline structures.

9. A method (200) according to any of the previous claims, wherein the method comprises
detecting a region corresponding with deviations in crystalline features, obtaining an indication on the density of deviations and spotting a region of interest, and,
decreasing the electron beam spot size for localizing a deviation in crystalline properties.

10. A controller (150) for controlling a system for characterizing a region in a sample under study by electron channeling contrast imaging, the sample under study comprising a first region having first crystalline properties and a second region having second crystalline properties different from the first crystalline properties, the controller (150) **characterised by** being configured for modulating the instantaneous relative angle α between an electron beam and the sample under study with a predetermined modulation frequency during an irradiating step, and for detecting backscattered or forward scattered electrons at the modulation frequency during a detection step.

11. A system (100) for characterizing a region in a sample under study by electron channeling contrast imaging, the sample under study comprising a first region having first crystalline properties and a second region having second crystalline properties different from the first crystalline properties, the system comprising
- a sample holder (110) for holding the sample under study
- an irradiation system (120) for irradiating the sample under study with an electron beam, the sample holder (110) and/or the irradiation system (120) allowing alignment for providing an average relative angle between the electron beam and the sample under study being selected so that a contribution in the backscattered or forward scattered signal of the first region is larger than a contribution of the second region,
- a detector (130) for detecting backscattered or forward scattered electrons upon interaction of the electron beam and the sample under study,
wherein the system (100) furthermore comprises a controller (150) according to claim 10.

12. A system (100) according to claim 11, wherein the system (100) comprises a lock-in amplifier for decoupling the contributions from a first region and the second region and/or wherein the system is equipped with a sample tilting means and/or a beam rocking means for inducing a modulation of the instantaneous relative angle α between the electron beam and the sample under study and/or wherein the system comprises a processor (140) for deriving a characteristic of the first region and/or the second region in the sample under study based on the detected backscattered or forward scattered electrons.

13. A system according to any of claims 11 to 12 wherein the irradiation source (120) furthermore is configurable for irradiating the sample under study with an electron beam having an average beam size selected to be larger than the size of the region to be characterized.

14. A computer program product comprising instructions which, when executed on a controller (150) in the system of any of claims 11 to 13, induce a method according to any of claims 1 to 9.

## Patentansprüche

1. Verfahren (200) zum Charakterisieren einer Region in einer untersuchten Probe, wobei die untersuchte Probe eine erste Region mit ersten kristallinen Eigenschaften und eine zweite Region mit zweiten kristallinen Eigenschaften, die sich von den ersten kristallinen Eigenschaften unterscheiden, umfasst, das Verfahren (200) umfassend:
- Bestrahlen (210) der untersuchten Probe mit einem Elektronenstrahl, wobei der durchschnittliche relative Winkel zwischen dem Elektronenstrahl und der untersuchten Probe so gewählt ist, dass ein Beitrag in dem rückgestreuten oder vorwärts gestreuten Signal der ersten Region größer ist als ein Beitrag der zweiten Region,
- Erfassen (220) der rückgestreuten oder vorwärts gestreuten Elektronen und
- Ableiten (230) eines Charakteristikums der ersten und/oder der zweiten Region in der untersuchten Probe aus den erfassten rückgestreuten oder vorwärts gestreuten Elektronen,
- wobei das Verfahren **dadurch gekennzeichnet ist, dass**
- das Bestrahlen (210) Modulieren (211) des momentanen relativen Winkels α zwischen dem Elektronenstrahl und der untersuchten Probe mit einer vorbestimmten Modulationsfrequenz während der Bestrahlung (210) umfasst und
- wobei das Erfassen (220) Erfassen (220) des resultierenden modulierten rückgestreuten oder vorwärts gestreuten Elektronensignals umfasst, das bei der vorbestimmten Modulationsfrequenz moduliert ist.

2. Verfahren (200) nach Anspruch 1, wobei die untersuchte Probe und die durchschnittliche Strahlengröße so gewählt sind, dass sie größer als die Größe der zu charakterisierenden Region sind.

3. Verfahren (200) nach einem der vorstehenden Ansprüche, wobei: das Erfassen (220) unter Verwendung von Lock-in-Verstärkung bei der Winkelmodulationsfrequenz durchgeführt wird.

4. Verfahren (200) nach einem der vorstehenden Ansprüche, wobei: der durchschnittliche relative Winkel zwischen dem Elektronenstrahl und der untersuchten Probe derart ist, dass die Kanalisierungsbedingung für die zweite Region erfüllt ist.

5. Verfahren (200) nach einem der vorstehenden Ansprüche, wobei die Modulation des momentanen relativen Winkels α zwischen dem Elektronenstrahl und der untersuchten Probe durch periodisches Kippen der Probe erhalten wird.

6. Verfahren (200) nach einem der vorstehenden Ansprüche, wobei die Modulation des momentanen relativen Winkels α zwischen dem Elektronenstrahl und der untersuchten Probe durch Elektronenstrahlschwenken erhalten wird.

7. Verfahren (200) nach einem der vorstehenden Ansprüche, wobei die ersten Regionen in der untersuchten Probe kristalline Defekte in einer kristallinen Struktur sind, wobei das Ableiten (230) Bestimmen (231) einer Dichte kristalliner Defekte umfasst.

8. Verfahren (200) nach einem der Ansprüche 1 bis 6, wobei die untersuchte Probe begrenzte kristalline Strukturen sind, die in einer nicht kristallinen Matrix eingebettet sind, wobei das Ableiten (230) Bestimmen (231) einer Dichte von Abweichungen in den begrenzten kristallinen Strukturen umfasst.

9. Verfahren (200) nach einem der vorstehenden Ansprüche, wobei das Verfahren umfasst
- Erfassen einer Region, die Abweichungen in kristallinen Merkmalen entspricht,
- Erhalten einer Angabe der Dichte von Abweichungen und Auffinden einer Region von Interesse und
- Verringern der Elektronenstrahlpunktgröße zum Lokalisieren einer Abweichung in kristallinen Eigenschaften.

10. Steuerung (150) zum Steuern eines Systems zum Charakterisieren einer Region in einer untersuchten Probe durch Elektronenkanalisierung-Kontrastbildgebung, wobei die untersuchte Probe eine erste Region mit ersten kristallinen Eigenschaften und eine zweite Region mit zweiten kristallinen Eigenschaften, die sich von den ersten kristallinen Eigenschaften unterscheiden, umfasst, wobei die Steuerung (150) **dadurch gekennzeichnet ist, dass** sie zum Modulieren des momentanen relativen Winkels α zwischen einem Elektronenstrahl und der untersuchten Probe mit einer vorbestimmten Modulationsfrequenz während eines Bestrahlungsschritts und zum Erfassen von rückgestreuten oder vorwärts gestreuten Elektronen bei der Modulationsfrequenz während eines Erfassungsschritts konfiguriert ist.

11. System (100) zum Charakterisieren einer Region in einer untersuchten Probe durch Elektronenkanalisierung-Kontrastbildgebung, wobei die untersuchte Probe eine erste Region mit ersten kristallinen Eigenschaften und eine zweite Region mit zweiten kristallinen Eigenschaften, die sich von den ersten kristallinen Eigenschaften unterscheiden, umfasst, das System umfassend
- eine Probenhalterung (110) zum Halten der untersuchten Probe
- ein Bestrahlungssystem (120) zum Bestrahlen der untersuchten Probe mit einem Elektronenstrahl, wobei die Probenhalterung (110) und/oder das Bestrahlungssystem (120) Ausrichtung erlauben, um einen durchschnittlichen relativen Winkel zwischen dem Elektronenstrahl und der untersuchten Probe bereitzustellen, der so gewählt ist, dass ein Beitrag in dem rückgestreuten oder vorwärts gestreuten Signal der ersten Region größer ist als ein Beitrag der zweiten Region,
- einen Detektor (130) zum Erfassen von rückgestreuten oder vorwärts gestreuten Elektronen bei Interaktion des Elektronenstrahls und der untersuchten Probe,
- wobei das System (100) weiter eine Steuerung (150) nach Anspruch 10 umfasst.

12. System (100) nach Anspruch 11, wobei das System (100) einen Lock-in-Verstärker zum Entkoppeln der Beiträge von einer ersten Region und der zweiten Region umfasst und/oder wobei das System mit einem Probenkippmittel und/oder einem Strahlschwenkmittel zum Einleiten einer Modulation des momentanen relativen Winkels α zwischen dem Elektronenstrahl und der untersuchten Probe umfasst und/oder wobei das System einen Prozessor (140) zum Ableiten eines Charakteristikums der ersten Region und/oder der zweiten Region in der untersuchten Probe basierend auf den erfassten rückgestreuten oder vorwärts gestreuten Elektronen umfasst.

13. System nach einem der Ansprüche 11 bis 12, wobei die Bestrahlungsquelle (120) weiter zum Bestrahlen der untersuchten Probe mit einem Elektronenstrahl mit einer durchschnittlichen Strahlengröße konfigurierbar ist, die größer als die Größe der zu charakterisierenden Region gewählt ist.

14. Computerprogrammprodukt, umfassend Anweisungen, die, wenn auf einer Steuerung (150) in dem System nach einem der Ansprüche 11 bis 13 ausgeführt, ein Verfahren nach einem der Ansprüche 1 bis 9 einleiten.

## Revendications

1. Procédé (200) pour caractériser une région dans un échantillon à l'examen, l'échantillon à l'examen comprenant une première région ayant des premières propriétés cristallines et une seconde région ayant des secondes propriétés cristallines différentes des premières propriétés cristallines, le procédé (200) comprenant les étapes consistant à :
irradier (210) l'échantillon à l'examen avec un faisceau d'électrons, l'angle relatif moyen entre le faisceau d'électrons et l'échantillon à l'examen étant sélectionné de sorte qu'une contribution dans le signal rétrodiffusé ou diffusé vers l'avant de la première région soit supérieure à une contribution de la seconde région,
détecter (220) les électrons rétrodiffusés ou diffusés vers l'avant, et
extraire (230) une caractéristique de la première et/ou de la seconde région dans l'échantillon à l'examen des électrons rétrodiffusés ou diffusés vers l'avant détectés,
le procédé **caractérisé en ce que** :
ladite irradiation (210) comprend la modulation (211) de l'angle relatif instantané α entre le faisceau d'électrons et l'échantillon à l'examen avec une fréquence de modulation prédéterminée durant ladite irradiation (210), et
dans lequel ladite détection (220) comprend la détection (220) du signal d'électrons rétrodiffusé ou diffusé vers l'avant modulé résultant modulé à la fréquence de modulation prédéterminée.

2. Procédé (200) selon la revendication 1, dans lequel l'échantillon à l'examen et la taille de faisceau moyenne sont sélectionnés pour être supérieur à la taille de la région à caractériser.

3. Procédé (200) selon l'une quelconque des revendications précédentes, dans lequel : la détection (220) est effectuée en utilisant une amplification à détection synchrone à la fréquence de modulation d'angle.

4. Procédé (200) selon l'une quelconque des revendications précédentes, dans lequel : l'angle relatif moyen entre le faisceau d'électrons et l'échantillon à l'examen est tel que la condition de canalisation est remplie pour la seconde région.

5. Procédé (200) selon l'une quelconque des revendications précédentes, dans lequel la modulation de l'angle relatif instantané α entre le faisceau d'électrons et l'échantillon à l'examen est obtenue par une inclinaison périodique de l'échantillon.

6. Procédé (200) selon l'une quelconque des revendications précédentes, dans lequel la modulation de l'angle relatif instantané α entre le faisceau d'électrons et l'échantillon à l'examen est obtenue par un balancement de faisceau d'électrons.

7. Procédé (200) selon l'une quelconque des revendications précédentes, les premières régions dans l'échantillon à l'examen étant des défauts cristallins dans une structure cristalline, ladite extraction (230) comprenant la détermination (231) d'une densité de défauts cristallins.

8. Procédé (200) selon l'une quelconque des revendications 1 à 6, l'échantillon à l'examen étant des structures cristallines confinées intégrées dans une matrice non cristalline, ladite extraction (230) comprenant la détermination (231) d'une densité d'écarts dans les structures cristallines confinées.

9. Procédé (200) selon l'une quelconque des revendications précédentes, dans lequel le procédé comprend les étapes consistant à
détecter une région correspondant à des écarts dans des traits cristallins,
obtenir une indication sur la densité d'écarts et repérer une région d'intérêt, et,
diminuer la taille de point de faisceau d'électrons pour localiser un écart dans des propriétés cristallines.

10. Dispositif de commande (150) pour commander un système pour caractériser une région dans un échantillon à l'examen par une imagerie de contraste par canalisation d'électrons, l'échantillon à l'examen comprenant une première région ayant des premières propriétés cristallines et une seconde région ayant des secondes propriétés cristallines différentes des premières propriétés cristallines, le dispositif de commande (150) caractérisé en étant configuré pour moduler l'angle relatif instantané α entre un faisceau d'électrons et l'échantillon à l'examen avec une fréquence de modulation prédéterminée durant une étape d'irradiation, et pour détecter des électrons rétrodiffusés ou diffusés vers l'avant à la fréquence de modulation durant une étape de détection.

11. Système (100) pour caractériser une région dans un échantillon à l'examen par une imagerie de contraste par canalisation d'électrons, l'échantillon à l'examen comprenant une première région ayant des premières propriétés cristallines et une seconde région ayant des secondes propriétés cristallines différentes des premières propriétés cristallines, le système comprenant
- un support d'échantillons (110) pour supporter l'échantillon à l'examen
- un système d'irradiation (120) pour irradier l'échantillon à l'examen avec un faisceau d'électrons, le support d'échantillons (110) et/ou le système d'irradiation (120) permettant un alignement pour fournir un angle relatif moyen entre le faisceau d'électrons et l'échantillon à l'examen étant sélectionné de sorte qu'une contribution dans le signal rétrodiffusé ou diffusé vers l'avant de la première région soit supérieure à une contribution de la seconde région,
- un détecteur (130) pour détecter des électrons rétrodiffusés ou diffusés vers l'avant lors de l'interaction du faisceau d'électrons et de l'échantillon à l'examen,
dans lequel le système (100) comprend en outre un dispositif de commande (150) selon la revendication 10.

12. Système (100) selon la revendication 11, dans lequel le système (100) comprend un amplificateur à détection synchrone pour découpler les contributions d'une première région et de la seconde région et/ou dans lequel le système est équipé d'un moyen d'inclinaison d'échantillon et/ou d'un moyen de balancement de faisceau pour induire une modulation de l'angle relatif instantané α entre le faisceau d'électrons et l'échantillon à l'examen et/ou dans lequel le système comprend un processeur (140) pour extraire une caractéristique de la première région et/ou de la seconde région dans l'échantillon à l'examen sur la base des électrons rétrodiffusés ou diffusés vers l'avant détectés.

13. Système selon l'une quelconque des revendications 11 à 12, dans lequel la source d'irradiation (120) peut en outre être configurée pour irradier l'échantillon à l'examen avec un faisceau d'électrons ayant une taille de faisceau moyenne sélectionnée pour être supérieure à la taille de la région à caractériser.

14. Produit de programme informatique comprenant des instructions qui, lorsqu'elles sont exécutées sur un dispositif de commande (150) dans le système selon l'une quelconque des revendications 11 à 13, induisent un procédé selon l'une quelconque des revendications 1 à 9.
